# EUROPEAN PATENT SPECIFICATION

(11) **EP 2 277 179 B1**
(45) Date of publication and mention of the grant of the patent: **29.11.2017**
(21) Application number: 09749972.7
(22) Date of filing: 05.03.2009
(51) Int. Cl.: H01F 1/28, H01F 1/44, H05K 1/02, H05K 3/30, C08J 3/24, C08K 3/08, C08K 3/22, H01L 21/56, H01L 23/00, H01L 23/29, H01L 23/552, H01L 23/64, B05D 3/06, H01Q 9/04

(54) **MAGNETICALLY CONTROLLED POLYMER NANOCOMPOSITE MATERIAL AND METHODS FOR APPLYING AND CURING SAME, AND NANOMAGNETIC COMPOSITE FOR RF APPLICATIONS**
MAGNETISCH GESTEUERTES POLYMERNANOVERBUNDMATERIAL UND VERFAHREN ZU SEINER AUFTRAGUNG UND HÄRTUNG SOWIE NANOMAGNETVERBUND FÜR HF-ANWENDUNGEN
MATÉRIAU NANOCOMPOSITE POLYMÈRE À COMMANDE MAGNÉTIQUE, SES PROCÉDÉS D APPLICATION ET DE DURCISSEMENT, ET COMPOSITE NANOMAGNÉTIQUE POUR APPLICATIONS RF

(30) Priority: 23.05.2008 US 154486
(43) Date of publication of application: 26.01.2011
(73) Proprietor: Nokia Technologies Oy, 02610 Espoo (FI)
(72) Inventor: SEPPÄLÄ, Eira, FI-00510 Helsinki (FI); HEINO, Markku, FI-02210 Espoo (FI); OKSANEN, Markku, FI-00940 Helsinki (FI); LEHTINIEMI, Reijo, FI-00240 Helsinki (FI); IKONEN, Pekka, FI-02760 Espoo (FI); POHJAKALLIO, Maija, FI-02130 Espoo (FI); JOHANS, Christoffer, FI-02610 Espoo (FI); RAS, Robin, 02340 Espoo (FI); TIMONEN, Jaakko, FI-02150 Espoo (FI)
(74) Representative: Potter Clarkson LLP
(86) International application number: PCT/FI2009/050179
(87) International publication number: WO 2009/141488

(56) References cited:
- EP-A1- 1 365 479
- WO-A2-2008/118191
- JP-A- 2004 288 946
- KR-A- 20070 046 043
- US-A- 4 778 635
- US-A- 5 889 091
- US-A1- 2003 148 024
- US-A1- 2003 218 258
- US-A1- 2006 003 152
- US-A1- 2006 083 694
- US-A1- 2007 148 437
- US-A1- 2008 251 904
- US-A1- 2009 168 390
- US-A1- 2009 321 923
- US-B1- 6 406 988
- 'Conference Proceedings of the International Symposium on Advanced Packaging Materials: Processes, Properties and Interfaces, IEEE, 2005', 2005, ISBN 0-7803-9085-7 article RAJ, P.M. ET AL: 'Magnetic nanocomposites for organic compatible miniaturized antennas and inductors', pages 272 - 275, XP010799247

## Description

### TECHNICAL FIELD:

The exemplary and non-limiting embodiments of this invention relate generally to nanotechnology, material science and electronic assembly and packaging techniques, and relate also to radio frequency components and assemblies, such as antennas.

### BACKGROUND:

Various abbreviations that appear in the specification and/or in the drawing figures are defined as follows:
- COC: cyclic olefin copolymer
- EMC: electromagnetic compatible
- EMI: electromagnetic interference
- FEP: fluorinated ethylene propylene copolymer
- FM: ferromagnetic
- HDPE: high-density polyethylene
- LDPE: low-density polyethylene
- LLDPE: linear low-density polyethylene
- MNP: magnetic nanoparticle
- PP: polypropylene
- PS: polystyrene
- PTFE: polytetrafluoroethylene
- PVDF: polyvinylidene fluoride
- PWB: printed wiring board
- RF: radio frequency
- SPM: superparamagnetic
- SPS: syndiotactic polystyrene
- TEM: transmission electron microscopy
- VSWR: voltage standing wave ratio
- PIFA: planar inverted F antenna

Compounds based on thermoset polymers, such as epoxy and polyurethane, are widely used to support or embed electronic components on a substrate, such as PWB. Component under-filling (filling between the component and the underlying substrate) is performed using very low viscosity resins that rely on material spreading to fill shallow cavities by capillary force. To achieve low viscosity (sufficient material flow) and rapid curing the resin needs to be heated to high temperatures (typically 150-160 C for several minutes). This complicates control of the process and furthermore can introduce a risk of damage to the components.

Typically, a conductive filler material has an adverse influence on electro-mechanical performance of plastics, increasing dielectric loss and reducing mechanical properties of the host polymer.

One-component resins are treated using high temperatures (typically 150-160C) to achieve rapid curing. Drawbacks to this process include difficulty in controlling the material flow (e.g., leakage and/or not reaching all locations desired to be filled) and thermal shock/stresses that are induced into the components and/or their interfaces during curing.

Two-component resins (resin and curing agent(catalyst)) are typically more viscous and are cured at lower temperatures (often from room temperature to about 60C). However, this can be a slow process (several hours), and the higher viscosity can result in more difficulty in flowing the resin into all desired locations.

An example of one currently available fast curing one-component epoxy under-fill material is found in, e.g., Technical Data Sheet LOCTITE7 3593™, May 2005. An example of a two-component polyurethane for filling/encapsulation of electronics components is found in, for example, technical data sheet STYCAST™ 1090, Low Density, Syntactic Foam, Epoxy Encapsulant, Emerson & Cuming, January 2007.

High magnetic permeability materials currently available for RF designers, such as ferrites and normal metal-ceramic composites, suffer from increasing losses and decreasing permeability with increasing operating frequency. For RF component miniaturization beyond 1 GHz, such as for the transmitter chain and the antenna of wireless communication devices, the choices of materials are severely limited.

High frequency component miniaturization is typically based on low loss dielectric materials. One example is a small Bluetooth antenna that uses high dielectric constant ceramics or dielectric filters. Having controllable, low loss, high permeability materials would greatly enhance component miniaturization, as well as the control of inductance. However, this has not yet been adequately achieved for very high frequency applications due at least to the presence of magnetic losses.

### SUMMARY

The present invention comprises a material, method and apparatus as defined in the claims.

The foregoing and other problems are overcome, and other advantages are realized, by the use of the examples of this disclosure.

In a first aspect thereof the examples of this disclosure provide a material that comprises a curable matrix and nanoparticles having a magnetic property, said nanoparticles being present in a concentration sufficient to cause said curable matrix to exhibit flow in response to application of a magnetic field.

In another aspect thereof the examples of this disclosure provide a method that includes applying a filler material to at least one component, the filler material comprising a heat curable matrix and nanoparticles; and applying an electromagnetic field to at least part of the filler material, where said nanoparticles are comprised of a core capable of being heated by the electromagnetic field to a temperature sufficient to at least partially cure the surrounding matrix.

In another aspect thereof the examples of this disclosure provide a method that includes applying a filler material to at least one component, the filler material comprising a matrix containing nanoparticles, said nanoparticles having a magnetic property and being present in a concentration sufficient to cause said matrix to flow in response to application of a magnetic field; and generating a magnetic field so as to guide the matrix into a space to be filled.

In another aspect thereof the examples of this disclosure provide an apparatus that includes a substrate and at least one component supported by said substrate, said substrate comprising a polymer containing nanoparticles forming a nanocomposite material having predetermined electromagnetic properties, including dielectric permittivity, magnetic permeability and dissipation factor, at a radio frequency of interest.

In yet another aspect thereof the examples of this disclosure provide an apparatus that includes a nanocomposite material comprised of nanoparticles in a polymeric matrix, said nanocomposite material disposed with and electromagnetically coupled to at least one radio frequency antenna element and exhibiting, at a radio frequency of interest, a relative magnetic permeability real part Re(µr) of at least 1.5, a

EP1365479A1 describes an anisotropically conductive connector, by which positioning, and holding and fixing to a wafer to be inspected can be conducted with ease even when the wafer has a large area, and the pitch of electrodes to be inspected is small, and moreover good conductivity can be achieved as to all conductive parts, and insulating property between adjacent conductive parts can be achieved, a production process thereof, and a probe member. The anisotropically conductive connector comprises a frame plate having a plurality of anisotropically conductive film-arranging holes formed corresponding to regions of electrodes to be inspected of a wafer, and a plurality of elastic anisotropically conductive films arranged in the respective anisotropically conductive film-arranging holes and supported by the inner peripheral edge thereabout. Each of the elastic anisotropically conductive films is composed of a functional part composed of a plurality of conductive parts arranged corresponding to the electrodes to be inspected, containing conductive particles exhibiting magnetism at a high density and extending in the thickness-wise direction of the film and insulating parts mutually insulating these conductive parts, and a supported part integrally formed at a peripheral edge of the functional part and fixed to the inner periphery about the anisotropically conductive film-arranging hole. The supported part contains the conductive particles exhibiting magnetism.

US6406988B1 describes a magnetic metal mask fabricated of a membrane of magnetic material that can be placed temporarily onto the face of a semiconductor wafer or of a circuit or other substrate. When properly positioned with respect to the wafer or substrate, such as by relational guide holes, the mask is held in place by the magnetic forces produced by a controllable electromagnet. Contact pad openings in the magnetic metal mask are formed by suitable means such as laser cutting or photo-etching. The magnetic metal mask may include a flexible interface layer on the side facing the wafer or substrate to assure tight sealing thereto, so as to reduce smearing and bridging of the conductive adhesive paste and avoid bridging between contact pads that might otherwise occur during deposition of the paste.

KR20070046043A and EP1973119A2 describe an anisotropic conductive film used for adhering IC, e.g., LCD displays, etc. The conductive film is characterized by comprising a thermosetting adhesive, super-paramagnetic metal oxide nano-particles, and conductive particles, the super-paramagnetic metal oxide nano-particles and the conductive particles being dispersed in a thermosetting composition. With such a configuration, low temperature curing may be implemented by means of high frequencies and positions of particles can be controlled by means of a magnetic field in adhering IC, e.g., LCD displays, so that greater connection reliability is achieved for connection electrodes of fine pitches.

JP2004288946A describes a method for sufficiently hardening an insulating adhesive agent protruding around a semiconductor chip when mounting the semiconductor chip on a circuit board via the thermosetting insulating adhesive agent. Magnetic particles 5 in an insulating adhesive agent 6 composed of a thermosetting epoxy resin or the like are particles of a magnetic material such as iron, nickel, cobalt, or their alloy. A semiconductor chip 2 sucked to a vacuum pickup tool 12 is pressed to the insulating adhesive agent 6 by the vacuum pickup tool 12 exercising a necessary force on the semiconductor chip 2, and, at the same time, a high-frequency current is applied to a coil 11 from a high-frequency current generator for the generation of a high-frequency magnetic field. The semiconductor chip 2 pressed by the vacuum pickup tool 12 sinks into the insulating adhesive agent 6, and the magnetic particles 5 in the magnetic field are heated by electromagnetic induction for hardening the insulating adhesive agent 6. Since the magnetic particles 5 are dispersed almost uniformly throughout the insulating adhesive agent 6, even the part of the insulating adhesive agent 6 protruding along the periphery of the semiconductor chip 2 is sufficiently hardened.
loss tangent of relative magnetic permeability no larger than about 0.1, a relative permittivity (dielectric constant) that is greater than about 1.2 and a loss tangent of relative permittivity that is not greater than about 0.1.

### BRIEF DESCRIPTION OF THE DRAWINGS

In the attached Drawing Figures:
Figure 1A shows an enlarged view of a magnetic polymer nanocomposite material comprised of a MNPs dispersed in a polymer matrix.
Figure 1B shows one of the MNPs of Figure 1A.
Figure 2 is a representation of a TEM micrograph that illustrates a substantially homogenous size distribution of synthesized Co nanoparticles.
Figure 3 depicts the use of an external magnetic field to guide the magnetic polymer nanocomposite material of Figure 1A into a void to be filled.
Figure 4 depicts the use of an external alternating electromagnetic field to cure the magnetic polymer nanocomposite material of Figure 1A by inductive heating of the MNPs, and resulting dissipation of heat into the heat curable polymer matrix.
Figure 5 shows an example of the use of these exemplary embodiments with an assembly that includes an EMI shield (can).
Figure 6 shows an enlarged cross-sectional view of an embodiment of a patch (planar) antenna assembly that includes a substrate that is constructed in accordance with the exemplary embodiments of this invention.
Figure 7 shows an enlarged elevational view of an exemplary antenna structure that includes a substrate supporting an antenna element, where the substrate is constructed in accordance with the exemplary embodiments.
Figure 8 is a graph that shows a simulated impedance response for the antenna structure shown in Figure 7.

### DETAILED DESCRIPTION

The exemplary embodiments of this invention provide a novel nanocomposite material containing a thermoset polymer and MNPs with controlled electro-mechanical properties that are beneficially used, for example, as a filler or an under-fill compound for electronic components. The exemplary embodiments provide novel techniques to at least one of feed and cure the nanocomposite material in order to, for example, protect components on a printed wiring board (PWB) and to fabricate robust modules which can be readily integrated with device mechanics via, for example, insert molding.

The exemplary embodiments use MNPs to guide and control the flow of a thermoset heat curable resin. The flow control can be used to accommodate constricted cavities and flow paths. Furthermore, the MNPs are utilized in curing the thermoset resin by inductive heating of the surrounding thermoset polymer matrix within which the MNPs are contained.

The exemplary embodiments of this invention overcome the problems discussed above by the use of very small (nanometer scale) magnetic metal-containing particles that may be well dispersed within a polymer resin or an epoxy or another material capable of being cured into a solid or semi-solid state, resulting in controllable electro-magnetic properties.

The exemplary embodiments further overcome the problems discussed above by providing a polymer nanocomposite material that exhibits specific and highly controllable electromagnetic properties that enable high performance and miniaturization of RF antennas and other RF handling components and circuits.

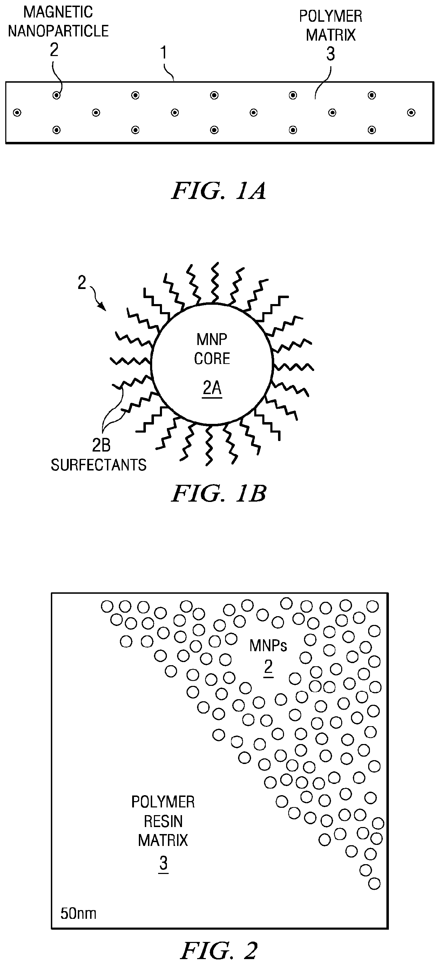

Referring to Figures 1A, 1B and 2, the exemplary embodiments of this invention provide a magnetic polymer nanocomposite material 1 with controlled and tailorable electromagnetic properties and optimal processability. The polymer material is inherently a good dielectric with tailorable magnetic characteristics. The dissipation factor and volume resistivity may be adjusted to a low level as needed typically for under-filling and encapsulation of components. The magnetic polymer nanocomposite material 1 contains nanometer-scale magnetic particles (magnetic nanoparticles MNPs (e.g., particles having a largest diameter of, for example, about 100nm or less)) 2 that may be dispersed uniformly within a thermoset polymer matrix 3. Each MNP 2 may be considered to include a MNP core 2A and surfactants 2B to more tightly couple the MNP core 2A to the surrounding polymer matrix 3. The magnetic polymer nanocomposite material 1 behaves in a plastic-like manner, and in accordance with one exemplary embodiment the flow and solidification (curing) of the magnetic polymer nanocomposite material 1 can be guided by application of an external magnetic field.

Note in Figure 2 that the MNPs 2 are shown in only half of the figure, and that the MNP density is exemplary. In general, the concentration of the MNPs 2 that are suspended in the polymer material 3 will be sufficient to cause the curable liquid polymer to flow in response to application of a magnetic field. Note that for at least some of the disclosed embodiments any reference herein to a curable "liquid" polymer is intended to encompass a polymer, or more generally a matrix material, that is in a state where flow (within a reasonable period of time) is possible, including the liquid state and a semi-liquid (or semi-solid) state, including gels.

Note that while described primarily in the context of the matrix 3 being or containing a polymer, in some exemplary embodiments non-polymeric matrix material may be employed, including one or more ceramics.

The use of these exemplary embodiments makes it possible to apply the magnetic polymer nanocomposite material 1 effectively in narrow cavities around/under electronic components on a PWB or other suitable substrate, and to solidify the easily flowed material quickly utilizing traditional heat sources (or by UV curing if applicable), or by the use of a hardener compound (curing agent/catalyst) that is mixed with the matrix material/MNPs prior to application to the component(s)/PWB.

In addition, the magnetic nanoparticles 2 provide as an alternative curing technique the use of inductive heating to cure the polymer matrix 3. This is advantageous for the protection of such components during manufacturing and/or during further process steps such as electronics integration to mechanics via insert molding.

The exemplary embodiments of this invention may be used in any application that involves thermoset polymers, where tailored material properties, guided flow of material and effective curing are desirable.

One exemplary application area is the protection of electronic (and/or optoelectronic) components mounted on a PWB. The magnetic polymer nanocomposite material 1 may be used as filler material to support and/or embed such components when building robust modular structures utilized, for example, to combine electronic and/or optic components to device mechanics via insert molding.

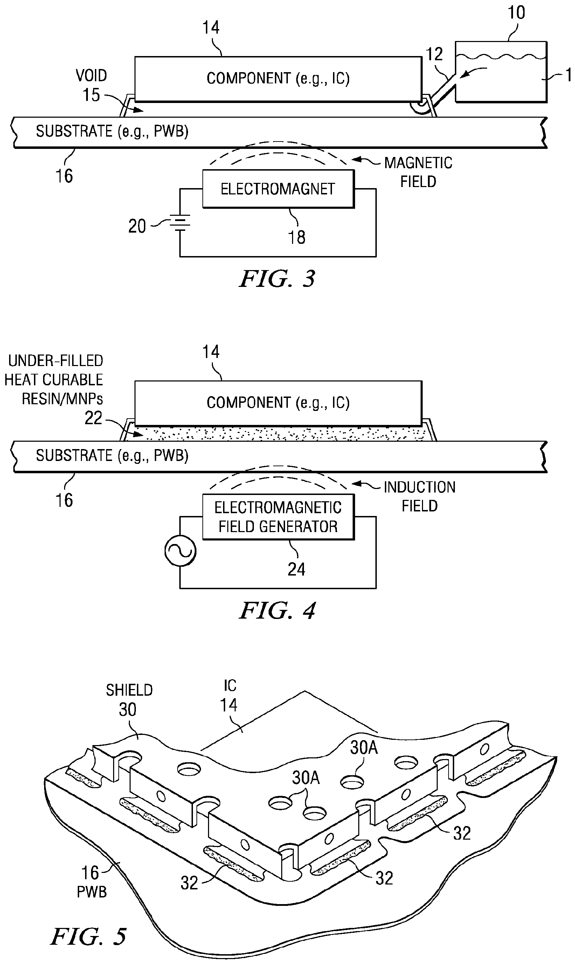

Figure 3 depicts the use of an external magnetic field to guide the magnetic polymer nanocomposite material 1 into a void to be filled. In this example the magnetic polymer nanocomposite material 1 is contained within a reservoir 10 having a channel 12 through which the magnetic polymer nanocomposite material 1 can flow (e.g., the magnetic polymer nanocomposite material 1 may be contained within a syringe). In this non-limiting example the void 15 to be filled is between a component 14, such as an integrated circuit chip, and a substrate 16, such as a PWB. The under-filling process involves applying the magnetic polymer nanocomposite material 1 so as to fill or substantially fill the void 15, and during this process to apply a magnetic field from, for example, an electromagnet 18 connected to a power source (shown for convenience as a battery 20). Note that a permanent magnet could be used as well. The MNPs 2 are attracted by the magnetic field and result in a controllable flow of the surrounding resin matrix 3 throughout the void 15.

Figure 5 shows another embodiment, where an EMI shield 30 is disposed on the PWB 16 and contains at least one component, such as integrated circuit 14. In this embodiment the magnetic polymer nanocomposite material 1 can be flowed through openings 30A in the shield 30 as described above, and then subsequently cured to embed the IC 14 within the dielectric material.

In the embodiments of Figures 3 and 5 it should be appreciated that the magnetic polymer nanocomposite material 1 may also be used to provide a coating upon a component (an overcoat), as well as to encapsulate a component.

These exemplary embodiments may also provide controlled electromagnetic properties including, but not limited to, dielectric permittivity, magnetic permeability and dissipation factor.

Further in this regard, the properties of the magnetic polymer nanocomposite material 1 may be tailored based on the specific requirements of an application of interest. The small size, good dispersion, and electromagnetic characteristics of the MNPs 2, as well as the flowability, softness/hardness and low dissipation factor of the dielectric polymer resin 3, form the basis of the nanocomposite properties. Essentially the magnetic polymer nanocomposite material 1 behaves like a plastic (where the hardness can be varied by cross-link density and type of polymer). Epoxy polymers or polyurethanes may be used to provide the resin matrix 3. The small MNPs 2 have sufficient magnetic properties to be utilized in guiding the flow and curing of the resin 3, without sacrificing the electrical and mechanical properties.

The MNPs 2 can be constructed of any magnetic material (e.g., metals such as Fe, Co, Ni, and alloys such as FePt, as well as certain oxides such as Fe₃O₄). Ferromagnetic MNPs 2 may be readily utilized for the guided flow and curing aspects, however they may tend to modify the composite properties as well (permanently magnetized). Superparamagnetic materials, in contrast, are magnetized only when the external magnetic field is present, and thus may be more advantageously used when optimized dielectric properties are needed (as discussed in further detail below). As is also discussed in greater detail below, the magnetic properties of a material are determined by its quantum mechanical behavior, and of these properties the magnetic anisotropy energy is of most interest.

In one exemplary and non-limiting embodiment cobalt nanoparticles 2 are suspended within an epoxy matrix 3. Small Co MNPs 2 with even size distribution may be created using appropriate surfactants 2B. Note that the nanocomposite properties can be tailored here by varying the size, inter-particle distance and compatibility with the polymer matrix 3. With cobalt it is important to note that MNPs 2 with mean diameter (largest dimension, as the MNPs 2 may not be spherical in shape) of less than about 10 nm are superparamagnetic, while those with diameters of several tens of nanometers are ferromagnetic.

As was discussed above, an aspect of these exemplary embodiments is guided deposition (filling) using an external magnetic field.

Further in this regard, the use of the magnetic polymer nanocomposite material 1 offers a significant advantage for manufacturing as an external electromagnetic field can be used to attract the magnetic polymer nanocomposite material 1 into narrow/shallow cavities, thereby guiding the material into desired locations. As the MNP 2 dispersion in the matrix 3 can be very homogeneous, and the MNPs 2 are well attached to the polymer matrix 3 by the surfactants 2B, guiding the movement of MNPs 2 also guides and controls the flow of the polymer resin matrix 3. Unlike traditional under-filling of components, which relies only on capillary forces and very low-viscosity resins (which easily leak, and which are still difficult to flow into all cavities), the exemplary embodiments of this invention provide a rapid and reliable technique to spread filler material. Furthermore, the viscosity level of the magnetic polymer nanocomposite material 1 can be adjusted or tuned to meet the needs of a particular application.

In addition, it is also within the scope of these exemplary embodiments to provide the MNPs 2 so that they that lack good MNP/polymer adhesion (e.g., MNP cores 2Awithout the surfactants 2B). Applying the magnetic field to such a magnetic polymer nanocomposite material 1 may be utilized to attract the MNPs 2 to desired locations, e.g., under shielding can walls so as to complete the EMI shielding between the lower edge of the can wall and underlying substrate material (e.g., see the regions 32 in Figure 5). This technique may thus be used to create highly dielectric and slightly conductive areas of the same material.

That is, application of the magnetic field can cause the MNPs 2 to migrate in a particular direction within the matrix 3, resulting in a concentration gradient of the MNPs 2 within the volume of the matrix 3. The presence of such a concentration gradient can result in the material exhibiting non-uniform electrical and/or mechanical properties throughout the bulk of the material, which may be advantageous for certain applications. For example, one may consider Figure 2 to show such a MNP concentration gradient, if one assumes that the MNPs 2 were attracted to the upper right portion of the liquid matrix 3 by application of a magnetic field, and that the polymer matrix 3 was subsequently cured (hardened) to fix the MNPs 2 in place.

As was also briefly described above, a further aspect of the exemplary embodiments of this invention relates to local curing of the matrix 3 utilizing an alternating electromagnetic field.

Further in this regard, and as was also discussed, traditionally filler materials are cured by high temperature (whole assembly heated) or by using two-component materials (resin plus hardener). The use of the former procedure may induce thermal stresses to the assembly, components and/or their interfaces, while the latter procedure typically requires a considerable amount of time to complete (e.g., hours).

Referring to Figure 4, by the use of this aspect of the invention the magnetic polymer nanocomposite material 1 may be cured without the use of a traditional thermal treatment by the use of an alternating electromagnetic field generator 24 to generate an induction field that results in localized heating in the MNPs 2 (e.g., Co MNPs) that results in each MNP 2 dissipating heat into the surrounding polymer matrix 3. This increase in temperature activates the cross-linking catalyst in the polymer resin 3 resulting in curing the polymer matrix 3. This type of local curing can quickly convert the highly fluidic material to a solid or semi-solid (e.g., gel-like) state (if sufficient for the intended application), and avoids the problems inherent in the conventional high temperature treatment of the entire structure, thereby minimizing a potential to cause component damage and thus increasing reliability. As shown in Figure 4, the exemplary under-filled heat curable resin/MNP material 22 (applied as in Figure 3) may be cured by the localized application of the induction field through the substrate 16. The heating may be controlled by selecting the frequency, which can vary within a wide range. In large scale industrial equipment 50 Hz (or 60 Hz, supply voltage frequency) is widely used. However, if only the surface is to be heated directly, several tens of MHz can be used as well. An exemplary operating frequency for the field generator 24 may in the ISM band, e.g., at about 13.56 MHz.

As can be appreciated, the use of this technique provides a possibility to cure the magnetic polymer nanocomposite material 1 only in selected areas on a PWB (or any other substrate) by applying the electromagnetic field locally. Any uncured material may be subsequently rinsed away.

The use of these exemplary embodiments provides novel techniques to process thermoset polymer resins. The use of a nanocomposite material containing the nanometer scale MNPs 2 beneficially enables for guiding the flow and curing the material by inductive heating, without sacrificing the electrical and mechanical properties of the thermoset polymer resin. In addition, the use of these exemplary embodiments provides improved manufacturability by enabling filler material feeding/dosing in difficult locations, such as within narrow cavities. The use of these exemplary embodiments also provides improved reliability through the use of rapid curing of the polymer resin, via inductive heating of the MNPs 2, to a gel-like or solid state without causing a thermal shock to the components/substrate. The use of these exemplary embodiments further provides a novel thermoset polymer-based magnetic nanocomposite material whose properties may be tailored by the MNPs 2 (e.g., size, amount, inter-particle distance, surfactant, adhesion to polymer) and by the selected polymer resin (e.g., soft to hard, cross-link density, 1-component or 2-component).

Furthermore, the use of magnetic materials for very high radio frequency (RF) components enables miniaturization of antennas, RF filters, electromagnetic compatible (EMC) shields in mobile phones and similar devices using RF technology. To address the need to provide materials that offer high magnetic permeability and low loss at frequencies beyond 1 GHz, the use of the MNPs 2 in the polymer matrix 3 combines relatively high magnetic permeability with low magnetic losses. This is due at least to the fact that the magnetic behavior of materials changes when the size of the particle approaches a few nanometers.

The exemplary embodiments of this invention thus also encompass a polymer nanocomposite material with specific and highly controllable electromagnetic properties enabling high performance and miniaturization of RF antennas and other RF components and circuits.

The exemplary embodiments include manufacturing methods, materials selection and morphology of the material, as well as the beneficial magnetic properties of the material obtained by making certain selections. The beneficial properties obtained at, for example, 1 GHz, 2 GHz, and 5 GHz include, but are not limited to the following.

First, the relative magnetic permeability real part Re(µᵣ) is at least 1.5.

Second, the loss tangent of the relative magnetic permeability is not greater than about 0.1.

Third, the relative permittivity (dielectric constant) may be between about 1 and 4 for antenna applications, and greater than, for example, about 4 for other applications.

Fourth, the loss tangent of relative permittivity is not larger than about 0.1.

The use of the exemplary embodiments enables producing a polymer composite material with high magnetic permeability and low dielectric permittivity and dissipation factor at high frequencies (e.g., 1-5 GHz (10⁹ Hz) or higher).

The magnetic nanocomposite with controlled electromagnetic properties employs the nanometer scale magnetic nanoparticles (MNP) 2 with controlled size and type that may be evenly embedded within the polymer material matrix 3 with low inherent dielectric losses. The small size and potentially substantially uniform dispersion of the MNPs 2 in the matrix 3 reduces dielectric losses while optimizing the magnetic permeability.

As was noted above, the MNPs 2 may be either ferromagnetic (FM) or superparamagnetic (SPM). For most magnetic materials, such as cobalt and iron, the particle size determines the type of magnetism, with the smaller particles (for Co below about 15 nm) being superparamagnetic while the larger particles (larger than about 15 nm) being ferromagnetic. The critical particle sizes depend on material and possibly also on the crystallographic structure: e.g., HCP (hexagonal close-packed) Co has a critical size of 15 nm, whereas FCC (face-centred cubic) Co has a critical size of only 7 nm. For other metals and metal-containing compounds the dimensions can vary widely, for example, the critical size for Ni is about 55 nm, while for Fe₃O₄ is it about 128 nm.

As was also noted above, the MNPs 2 may be formed of any magnetic material (e.g., metals such as Fe, Co, Ni, and alloys such as FePt, as well as certain oxides such as Fe₃O₄). The superparamagnetic MNPs 2, which are magnetized only when the external magnetic field is present, are more attractive when it is desired to minimize losses. In the exemplary embodiments superparamagnetic MNPs 2 with a narrow size distribution are preferred for use.

As was shown in Figure 1B, in the synthesis phase the MNP cores 2A are typically covered by a shell of organic surfactant molecules 2B which stabilizes the dispersion and results in a more homogeneous size distribution of the MNPs 2. Furthermore, by using suitable surfactants 2B the interactions between the MNPs 2 and the polymer matrix 3 can be controlled. The surfactants 2B interact with the polymer matrix 3 by chemical bonding and/or by physical mixing (via van der Waals forces) leading to stable arrays of MNPs 2 within the polymer matrix 3. This forms the basis for both well controlled electromagnetic (high permeability with low losses) and balanced mechanical properties (strength and flexibility).

In some exemplary embodiments, such as those described in relation to radio frequency (RF) applications, the polymer is selected to have a sufficiently low dielectric permittivity and, in particular, a low dissipation factor at high frequencies. Various different polymers may be used. Typically non-polar polymers, such as polystyrene (PS), syndiotactic polystyrene (SPS), polyethylenes (LDPE, LLDPE or HDPE), polypropylene (PP), cyclic olefin copolymer (COC), polyisobutylene, polyisoprene, polybutadiene orfluoropolymers (PTFE, FEP, PVDF) are attractive candidates due to their inherently low permittivity and dissipation factor. Furthermore, any copolymers containing similar chemical moieties (monomers) as those polymers mentioned above or their blends can be used. At least for environmental reasons polymers others than fluoropolymers are more useful. In some cases a polar polymer such as polycarbonate, or thermoset polymers such as epoxies, polyurethanes and silicones, can be used to form the matrix 3.

In order to further reduce the permittivity the polymer nanocomposite material 1 may also be foamed using standard physical foaming (e.g., adding nitrogen or carbon dioxide gas) or chemical foaming (e.g., using blowing agents degrading at the processing temperature) techniques. It is within the scope of the invention to form gels or aerogels utilizing MNP cores 2A covered with surfactants 2B that are dispersed in a loose network of binding polymer 3, thereby providing voids within the polymer nanocomposite material.

Note that the final composite properties depend on at least the type, electromagnetic characteristics, size and concentration of the MNPs 2, the dielectric characteristics of the polymer matrix 3 (permittivity, dissipation factor) and, to some extent, the interactions between the MNPs 2 and polymer matrix 3. As a result, there are a number of variables that can be adjusted in order to obtain a material having the desired RF and physical properties. Outside the scope of the invention, the permeability may be made tunable by using MNPs 2 which are not attached to the polymer matrix 3 (as discussed above, MNP cores 2A without surfactants 2B), as in this case the inter-particle distances may be varied dynamically by the use of an external electromagnetic field.

Selecting the size of the MNPs 2 depends at least in part on the magnetic material that forms the MNP core 2A. As was noted above, the magnetic properties of a material are determined by its quantum mechanical behavior, and of these properties the magnetic anisotropy energy is of most interest. The magnetic anisotropy energy defines the minimum size of a magnetic domain. If the minimum size of the magnetic domain is larger than the particle size, the magnetic nanoparticle will, even when not exposed to an external magnetic field, comprise only a single magnetic domain wherein all the of outer shell electron spins of the magnetic atoms point to the same direction. This phenomenon is known as superparamagnetism, as opposed to ferromagnetism. In ferromagnetism, at zero external magnetic field, several domains of differently oriented spins (usually directed along the surface of the material) occupy the material. When a ferromagnetic material is loaded by an alternating magnetic field, it magnetizes in a non-linear fashion, and a so-called hysteresis loop is formed. In superparamagnetic particles, when under an alternating magnetic field, the magnetization curve follows the same path when loaded with opposite magnetic field directions, and the hysteresis loop area collapses. Hence, the losses created by the hysteresis loop (which transform to heat energy) are minimized. However, it is not only the size of the particle that determines whether the particle is ferromagnetic or paramagnetic, but also the temperature and other factors. Of these other factors the phase of the particle (e.g., a face-centered cubic or a hexagonal close-packed structure), as well as the purity, e.g., amount/existence of dislocations, interstitials, vacancies, and grain boundaries (whether the particle is polycrystalline or single crystal) define for a given magnetic material at what size it is capable of exhibiting superparamagnetic or ferromagnetic properties.

The relative permeability of a magnetic material is also based on the quantum mechanical properties of the material and varies from one magnetic material to another. Hence, for a desired permeability value, in addition to the loss minimization achieved by the use of superparamagnetic particles, the selection of the magnetic material is of concern.

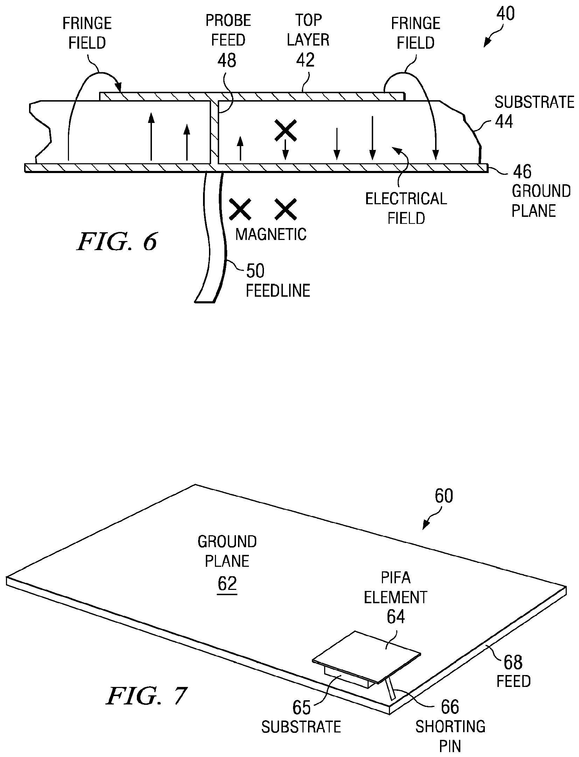

Referring to Figure 6 there is shown in cross section an embodiment of a patch (planar) antenna assembly 40. The antenna assembly 40 includes the patch antenna element 42 disposed upon a first surface of a substrate 44. A ground plane 46 can be disposed on the opposite second surface of the substrate 44. Passing through the substrate 44 and electrically coupled with the patch element 42 is a probe feed conductor 48 that is connected with a feedline 50. An electric field exists within the substrate 46 between the patch element 42 and the ground plane 46, and fringe fields exist at the edges of the patch element 42.

Magnetic and dielectric materials are used in the antenna assembly 40 in the following manner. Considering the typical patch antenna as shown in Figure 6, the electric field is between the ground plane 46 and the patch element 42 and is perpendicular to them. The magnetic field is parallel to the ground plane 46 (indicated by the Xs) and the antenna element 42 and is present both outside of the antenna assembly 40 and within the antenna assembly 40. If the material between the patch element 42 and the ground plane 46 has either high magnetic permeability µ or high dielectric constant ε the inductive or the capacitive contributions to the antenna resonance frequency are increased, which lowers the antenna resonance frequency. In other words, a physically smaller antenna can provide the desired resonance frequency. The antenna resonance frequency is proportional 1/Sqrt(µε). In addition, the bandwidth of the antenna is proportional to µ/ε. This means that it is desirable to engineer both µ and ε if possible since the same antenna size can be obtained with different combinations of µ and ε, but the bandwidth will be different. The dielectric or magnetic losses contribute directly to antenna losses and correspondingly lower the antenna gain.

The use of the MNP polymer material 1 in the substrate 44 is thus beneficial, as it enables the antenna assembly 40 to exhibit desired values of magnetic permeability µ and dielectric constant ε. The resulting high magnetic permeability and low loss that is achievable is of benefit in at least the following areas. In antenna miniaturization the use of the magnetic polymer nanocomposite material 1 allows for size scaling, without narrowing the antenna VSWR bandwidth. Further by example, inductive elements in RF impedance matching networks, filters and chokes can be made smaller without a reduction in performance due to losses. Further by example, the combination of magnetic and dielectric properties at low loss allows for the engineering of both magnetic and electric contributions in RF elements, such as in filter resonators.

The use of the magnetic polymer nanocomposite material 1 enables one to realize an exceptional property combination of high permeability, low permittivity and low dissipation factor at high frequencies, in addition to the presence of plastic or elastomer-like properties and moldability into any desired shape. The use of the magnetic polymer nanocomposite material 1 further enables one to fabricate flexible substrates for thin microstrip or printed antenna structures, resulting in a flexible high performance antenna structure. The use of the magnetic polymer nanocomposite material 1 also enables one to realize tunability and flexibility of antenna design due at least to the fact that the smaller resulting size of the antenna assembly enables more positions to become available for placing the antenna structure 40 and, due at least to the tunability that is possible by controlling the composite properties, the antenna may be optimized for functioning at different frequencies.

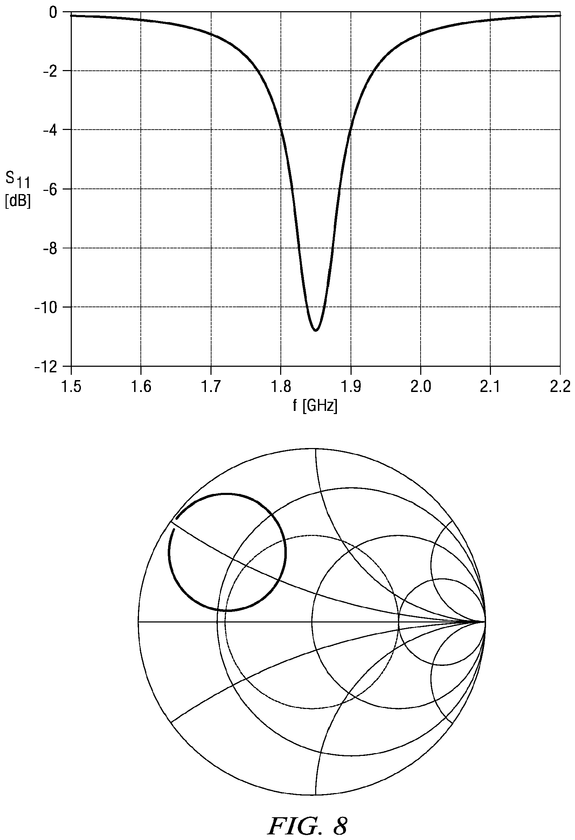

Figure 7 shows an exemplary antenna structure 60 (e.g., a PIFA antenna structure) that can be fabricated using the exemplary embodiments of this invention. In this non-limiting example there is a ground plane 62, a PIFA element 64 supported above the ground plane 62 by a dielectric substrate 65, a shorting pin 66 and a feed 68. The overall structure may have dimensions of about 40mm by 100mm, the PIFA element 64 may have dimensions of between about 10-15mm (square), and the thickness of the substrate 65 may be greater than 2mm, e.g., about 2.3-2.4mm. The substrate 65 is constructed in accordance with the exemplary embodiments herein, and may have an area of about 10x10mm² and is disposed symmetrically under the PIFA element 64. It is within the scope of these exemplary embodiments to stack, e.g., three layers (most strongly polarizable) to provide a total substrate 65 thickness of about 2.4mm. The individual layers of the substrate 65 have different values for ε and µ, and the effective permittivity and permeability can be determined using equations for uniaxial magneto-dielectrics. The normal component of permittivity ε_{eff} may be about 3.7, and the tangential component of permeability µ_{eff} may be about 1.2. Figure 8 shows a simulated impedance response for the structure in a range of about 1.5-2.2 GHz.

In the exemplary embodiment shown in Figure 7 a suitable example of a polymer (matrix 3) of the substrate 65 may be polystyrene (dielectric constant about 2.7), and a suitable example of the MNPs 2 may be 80nm Cobalt particles having a concentration of less than about 5%, corresponding to a permeability of about 1.2.

It should be appreciated in view of the foregoing description that the exemplary embodiments of this invention provide a nanocomposite material (e.g., a polymer nanocomposite material) with specific and highly controllable electromagnetic properties enabling high performance and miniaturization of RF components, including RF antennas. The exemplary embodiments encompass at least two aspects of the material: the manufacturing method, materials selection, and morphology of the material, and the beneficial magnetic properties of the material that are obtained by making certain selections. The beneficial properties obtained at a radio frequency of interest, for example, at 1 GHz, 2 GHz, or 5 GHz, include, but are not limited to, a relative magnetic permeability real part Re(µr) of at least 1.5, a loss tangent of relative magnetic permeability no larger than about 0.1 , a relative permittivity (dielectric constant) that is greater than about 1.2 and a loss tangent of relative permittivity that is not greater than about 0.1.

It should be noted that while the RF-related embodiments discussed above may have been described largely in the context of thermoplastic polymers for fabricating the substrate 65, thermoset polymers such as epoxies, polyurethanes and silicone, may be used as well.

Note that in some applications of interest it may be desirable that the substrate material be flexible and possibly even stretchable. As such, the polymer may be of the elastomeric type, and a thermoplastic polymer that is used may thus be selected to be an elastomer. There are a number of copolymers, including styrene-based copolymers, that may be used to provide flexibility and/or stretchability to the substrate, such as the substrate that supports or contains an RF element, such as an RF antenna element.

Note as well that the magnetic polymer nanocomposite material 1 may be used as a substrate (e.g., the substrate 65), or as a cavity filler, or in other ways, such as being wrapped around the antenna element 64. In general, the magnetic polymer nanocomposite material 1 , however provided, is desirably electromagnetically coupled with the antenna radiator element, and it may lie beneath, or over, or around the element. Note that the antenna element 64 may be one used for receiving radio frequency signals, or transmitting radio frequency signals, or for both receiving and transmitting radio frequency signals.

While the exemplary embodiments have been described above in the context of certain metals, alloys, oxides, polymers, resins and the like, it should be appreciated that the exemplary embodiments of this invention are not limited for use with only the specifically mentioned examples.

Further, the MNPs 2 may be prepared in any suitable manner, such as by precipitation or mechanical grinding. Further, the surfactant used may be any suitable material selected to stabilize the MNP 2 dispersion in the material of the liquid or semi-liquid matrix 3 (before it is cured/hardened). Thus, the surfactants 2B should be chosen to interact with the polymers through van der Waals or electrostatic forces or covalent bonds, while the head groups may be functionalities that adsorb on the particle core 2A, for example, functionalities such as amines, carboxylic acids or silanes.

Further, it should be noted that the induction field used to heat the MNPs 2 and cure the resin of the polymer matrix 3 may be used alone, or in combination with conventional heat or optical curing procedures. In this latter case the use of the two heating procedures together may beneficially reduce the curing time, or possibly reduce the maximum temperature that is needed to be applied to the electronic assembly by the conventional heat source.

Further, it should be noted that these exemplary embodiments are not limited for use with MNPs 2 that are uniform with respect to composition and/or size, as in some applications of interest it may be desirable to provide mixtures of MNPs comprised of different metals/alloys/oxides of the same approximate size, or of different sizes, thereby enabling even further control over the resulting physical and/or electromagnetic properties of the resulting magnetic polymer nanocomposite material 1. Further in this regard the different types of particles may be uniformly mixed together within the magnetic polymer nanocomposite material 1, or they may physically segregated within the magnetic polymer nanocomposite material 1, or a graded composition of two or more types of MNPs 2 may be employed (as one non-limiting example, Co MNPs 2 within one portion of the volume of the matrix 3, Fe MNPs 2 within another portion of the volume of the matrix 3, and an intervening portion of the volume of the matrix 3 that contains both Co and Fe MNPs 2). In addition, it should be appreciated that the MNPs 2 may be provided with dimensions such that some portion of the population of MNPs exhibits ferromagnetism, while another portion of the population exhibits superparamagnetism. Further, in a given magnetic polymer nanocomposite material 1 there may be some MNPs 2 that include the surfactants 2B, while other MNPs 2 do not include the surfactants 2B, or that include a different type of surfactant providing a different type of interaction with the surrounding material of the matrix 3. Further, and as was indicated previously, a structure containing the magnetic polymer nanocomposite material 1 may be a monolithic structure, or it may be a multi-layered structure with each layer possibly being different in matrix and/or MNP composition that other layers. Further, it should be noted that these exemplary embodiments are not limited for use with only a single type of polymer in a given instance of the magnetic polymer nanocomposite material 1.

It should also be noted that the terms "connected," "coupled," or any variant thereof, mean any connection or coupling, either direct or indirect, between two or more elements, and may encompass the presence of one or more intermediate elements between two elements that are "connected" or "coupled" together. The coupling or connection between the elements can be physical, logical, or a combination thereof. As employed herein two elements may be considered to be "connected" or "coupled" together by the use of one or more wires, cables and/or printed electrical connections, as well as by the use of electromagnetic energy, such as electromagnetic energy having wavelengths in the radio frequency region, the microwave region and the optical (both visible and invisible) region, as several non-limiting and non-exhaustive examples.

Furthermore, some of the features of the various non-limiting and exemplary embodiments of this invention may be used to advantage without the corresponding use of other features.

For example, in some embodiments where a conventional polymer curing process is desired the MNPs 2 may be selected without regard for their ability to generate heat in response to application of an electromagnetic (induction) field. Alternatively, in other embodiments where the polymer resin is to be applied using conventional application methods (without the use of a guiding magnetic field), the MNPs 2 may be selected only with regard for their ability to generate heat in response to application of the electromagnetic (induction) field.

As such, the foregoing description should be considered as merely illustrative of the principles, teachings and exemplary embodiments of this invention, and not in limitation thereof.

## Claims

1. A material (1) comprising a curable matrix (3) and nanoparticles (2) having a magnetic property, said nanoparticles (2) being present in a concentration sufficient to cause said curable matrix (3) to exhibit flow in response to application of a magnetic field, where said nanoparticles (2) comprise a surfactant (2B) selected to reduce mobility of the nanoparticles (2) by tighter coupling to the matrix (3) before it is cured.

2. The material (1) of claim 1, where said magnetic property is one of a ferromagnetic or a superparamagnetic property.

3. The material (1) according to any preceding claim, where said nanoparticles (2) comprise at least one of a metal, a metal alloy and a metal-containing oxide.

4. The material (1) according to any preceding claim, where said nanoparticles (2) have a largest dimension of about 100 nm or less.

5. The material (1) according to any preceding claim, where said nanoparticles (2) comprise a metal-containing core (2A).

6. The material (1) according to any preceding claim, where said matrix (3) and said nanoparticles (2) are selected to provide controlled electromagnetic properties, including at least one of a relative magnetic permeability real part, a loss tangent of relative magnetic permeability, a relative permittivity and a loss tangent of relative permittivity, in a frequency range of interest.

7. A method comprising:
applying a material (1) to at least one component (14), the material (1) comprising a curable matrix (3) containing nanoparticles (2) having a magnetic property, said nanoparticles (2) being present in a concentration sufficient to cause said curable matrix (3) to exhibit flow in response to application of a magnetic field and comprising a surfactant (2B) selected to reduce mobility of the nanoparticles (2) in said matrix (3) before it is cured; and
generating a magnetic field so as to guide the curable matrix (3) into a space (15) to be filled.

8. The method of claim 7, further comprising applying an electromagnetic field to at least part of the material (1) resulting in localized heating of the nanoparticles (2) sufficient to at least partially cure the surrounding matrix (3).

9. An apparatus comprising a substrate (16) and at least one component (14) supported by said substrate (16), said substrate (16) comprising the material (1) of any of claims 1 to 6.

## Patentansprüche

1. Material (1), das eine härtbare Matrix (3) und Nanoteilchen (2) mit einer magnetischen Eigenschaft umfasst, wobei die Nanoteilchen (2) in einer Konzentration vorhanden sind, die ausreicht, um zu bewirken, dass die härtbare Matrix (3) ansprechend auf das Anlegen eines Magnetfelds einen Fluss zeigt, wobei die Nanoteilchen (2) ein oberflächenaktives Mittel (2B) umfassen, das ausgewählt ist, um die Beweglichkeit der Nanoteilchen (2) durch engeres Koppeln mit der Matrix (3), bevor sie gehärtet ist, zu verringern.

2. Material (1) nach Anspruch 1, wobei die magnetische Eigenschaft eine ferromagnetische oder eine superparamagnetische Eigenschaft ist.

3. Material (1) nach einem der vorhergehenden Ansprüche, wobei die Nanoteilchen (2) wenigstens eines von einem Metall, einer Metalllegierung und einem metallhaltigen Oxid umfassen.

4. Material (1) nach einem der vorhergehenden Ansprüche, wobei die Nanoteilchen (2) eine größte Abmessung von etwa 100 nm oder weniger aufweisen.

5. Material (1) nach einem der vorhergehenden Ansprüche, wobei die Nanoteilchen (2) einen metallhaltigen Kern (2A) umfassen.

6. Material (1) nach einem der vorhergehenden Ansprüche, wobei die Matrix (3) und die Nanoteilchen (2) ausgewählt sind, um gesteuerte elektromagnetische Eigenschaften, einschließlich zumindest einer von einem Realteil der relativen magnetischen Permeabilität, einer Verlusttangente der relativen magnetischen Permeabilität, einer relativen Permittivität und einer Verlusttangente der relativen Permittivität, in einem interessierenden Frequenzbereich bereitzustellen.

7. Verfahren, welches Folgendes umfasst:
Aufbringen eines Materials (1) auf wenigstens eine Komponente (14), wobei das Material (1) eine härtbare Matrix (3) umfasst, die Nanoteilchen (2) mit einer magnetischen Eigenschaft enthält, wobei die Nanoteilchen (2) in einer ausreichenden Konzentration vorhanden sind, um zu bewirken, dass die härtbare Matrix (3) ansprechend auf das Anlegen eines Magnetfelds einen Fluss zeigt, und ein oberflächenaktives Mittel (2B) umfassen, das ausgewählt ist, um die Beweglichkeit der Nanoteilchen (2) in der Matrix (3), bevor sie gehärtet ist, zu verringern, und
Erzeugen eines Magnetfelds, um die härtbare Matrix (3) in einen zu füllenden Raum (15) zu leiten.

8. Verfahren nach Anspruch 7, wobei ferner ein elektromagnetisches Feld auf zumindest einen Teil des Materials (1) angewendet wird, wodurch sich eine lokalisierte Erwärmung der Nanoteilchen (2) ergibt, die ausreicht, um die umgebende Matrix (3) zumindest teilweise zu härten.

9. Vorrichtung, die ein Substrat (16) und wenigstens eine Komponente (14), die von dem Substrat (16) getragen wird, umfasst, wobei das Substrat (16) das Material (1) nach einem der Ansprüche 1 bis 6 umfasst.

## Revendications

1. Matériau (1) comprenant une matrice durcissable (3) et des nanoparticules (2) ayant une propriété magnétique, lesdites nanoparticules (2) étant présentes en une concentration suffisante pour amener ladite matrice durcissable (3) à présenter un écoulement en réponse à l'application d'un champ magnétique, où lesdites nanoparticules (2) comprennent un tensioactif (2B) sélectionné pour réduire une mobilité des nanoparticules (2) par un couplage plus étroit à la matrice (3) avant qu'elle soit durcie.

2. Matériau (1) selon la revendication 1, où ladite propriété magnétique est l'une d'une propriété ferromagnétique ou superparamagnétique.

3. Matériau (1) selon l'une quelconque des revendications précédentes, où lesdites nanoparticules (2) comprennent au moins l'un d'un métal, d'un alliage en métal et d'un oxyde contenant du métal.

4. Matériau (1) selon l'une quelconque des revendications précédentes, où lesdites nanoparticules (2) ont une plus grande dimension d'environ 100 nm ou moins.

5. Matériau (1) selon l'une quelconque des revendications précédentes, où lesdites nanoparticules (2) comprennent un noyau contenant du métal (2A).

6. Matériau (1) selon l'une quelconque des revendications précédentes, où ladite matrice (3) et lesdites nanoparticules (2) sont sélectionnées pour fournir des propriétés électromagnétiques régulées, comportant au moins l'un d'une partie réelle de perméabilité magnétique relative, d'un facteur de dissipation de perméabilité magnétique relative, d'une permittivité relative et d'un facteur de dissipation de permittivité relative, dans une plage de fréquences d'intérêt.

7. Procédé comprenant :
l'application d'un matériau (1) à au moins un composant (14), le matériau (1) comprenant une matrice durcissable (3) contenant des nanoparticules (2) ayant une propriété magnétique, lesdites nanoparticules (2) étant présentes en une concentration suffisante pour amener ladite matrice durcissable (3) à présenter un écoulement en réponse à l'application d'un champ magnétique, et comprenant un tensioactif (2B) sélectionné pour réduire une mobilité des nanoparticules (2) dans ladite matrice (3) avant qu'elle soit durcie ; et
la génération d'un champ magnétique de façon à guider la matrice durcissable (3) dans un espace (15) à remplir.

8. Procédé selon la revendication 7, comprenant en outre l'application d'un champ électromagnétique à au moins une partie du matériau (1) se traduisant par un chauffage localisé des nanoparticules (2) suffisant pour durcir au moins partiellement la matrice (3) environnante.

9. Appareil comprenant un substrat (16) et au moins un composant (14) supporté par ledit substrat (16), ledit substrat (16) comprenant le matériau (1) de l'une quelconque des revendications 1 à 6.
